# EUROPEAN PATENT APPLICATION

(11) **EP 4 770 290 A1**
(43) Date of publication of application: **01.07.2026**
(21) Application number: 25210961.6
(22) Date of filing: 24.10.2025
(51) Int. Cl.: H05K 7/14

(54) **INVERTER AND ENERGY STORAGE SYSTEM INCLUDING THE SAME**

(30) Priority: 24.12.2024 KR 20240196143
(71) Applicant: Hanwha Solutions Corporation, Jung-gu Seoul 04541 (KR)
(72) Inventor: PARK, Je Hyun, 04541 Seoul (KR); CHOI, You Chang, 04541 Seoul (KR)
(74) Representative: Mooser, Sebastian Thomas

(57) **Abstract**

Provided is an inverter including a main case, a heat dissipation case that covers one side of the main case and has a plurality of heat dissipation fins, a circuit board unit arranged in an internal space defined by an assembly of the main case and the heat dissipation case, the circuit board unit having one or more circuit boards configured to mutually convert between direct current power and alternating current power, and a safety cover arranged in the internal space to cover the circuit board unit.

## Description

### BACKGROUND

### 1. Field

The present disclosure relates to an inverter and an energy storage system including the same.

### 2. Description of the Related Art

In general, an inverter is a device that converts direct current (DC) electricity generated by an electrical energy generation device, such as a solar module, into alternating current (AC) electricity, and stores electrical energy in a battery serving as a power storage device, and may also supply AC electricity to home appliances that consume AC electricity, and a power grid, and maintain power quality by adjusting an output voltage and frequency.

An inverter may be used as a standalone unit connected to a solar panel, a power grid, and the like, but may also be integrated with other external devices, such as an energy storage system (ESS), to serve as an all-in-one solution. This configuration may improve the efficiency of power conversion and storage.

### SUMMARY

The present disclosure provides an inverter with improved ease of installation and replacement, and an energy storage system including the inverter.

Additional aspects will be set forth in part in the description which follows and, in part, will be apparent from the description, or may be learned by practice of the presented embodiments of the disclosure.

An embodiment of the present disclosure provides an inverter including: a main case; a heat dissipation case that covers one side of the main case and has a plurality of heat dissipation fins; a circuit board unit arranged in an internal space defined by an assembly of the main case and the heat dissipation case, the circuit board unit having one or more circuit boards configured to mutually convert between direct current power and alternating current power; and a safety cover arranged in the internal space to cover the circuit board unit.

In an embodiment, the safety cover may include: a first cover body that covers the one or more circuit boards; and a second cover body arranged on one side of the first cover body, and at least some of the one or more circuit boards may be exposed through a connection space enclosed by the first cover body and the second cover body.

In an embodiment, one of the one or more circuit boards may include a connection terminal arranged in the connection space and to which an external cable is connected.

In an embodiment, the safety cover may further include a third cover body that is connected to the first cover body and the second cover body, and has a step with at least one of the first cover body and the second cover body.

In an embodiment, the safety cover may include a guide part that guides a position of a cable connected from an outside of the main case to a connection terminal of the one or more circuit boards.

In an embodiment, the safety cover may include: a main cover that covers at least a part of the circuit board unit; and a sub-cover that is connected to the main cover and covers a fuse mounted on the circuit board.

In an embodiment, the main cover may include a coupling hole in which at least a part of the fuse is arranged and the sub-cover is installed.

In an embodiment, the sub-cover may include: a coupling part having a locking protrusion that protrudes outward and is supported by the main cover; and slits arranged on opposite sides of the coupling part.

In an embodiment, the circuit board may be arranged such that the fuse protrudes into the coupling hole of the main cover, and the sub-cover may be assembled to protrude from the coupling hole to cover the fuse.

In addition, another embodiment of the present disclosure provides an energy storage system including: an inverter; and a storage device, wherein the inverter includes: a main case; a heat dissipation case that covers one side of the main case and has a plurality of heat dissipation fins; a circuit board unit arranged in an internal space defined by an assembly of the main case and the heat dissipation case, the circuit board unit having one or more circuit boards configured to mutually convert between direct current power and alternating current power; and a safety cover arranged in the internal space to cover the circuit board unit, and the inverter and the storage device are electrically connected to each other.

In an embodiment, the safety cover may include: a first cover body that covers the one or more circuit boards; and a second cover body arranged on one side of the first cover body, and at least some of the one or more circuit boards may be exposed through a connection space enclosed by the first cover body and the second cover body.

In an embodiment, the safety cover may further include a third cover body that is connected to the first cover body and the second cover body, and has a step with at least one of the first cover body and the second cover body.

In an embodiment, the safety cover may include: a main cover that covers at least a part of the circuit board unit; and a sub-cover that is connected to the main cover and covers a fuse mounted on the circuit board.

In an embodiment, the main cover may include a coupling hole in which at least a part of the fuse is arranged and the sub-cover is installed.

In an embodiment, the sub-cover may include: a coupling part having a locking protrusion that protrudes outward and is supported by the main cover; and slits arranged on opposite sides of the coupling part.

Other aspects, features, advantages other than those described above will become apparent from the following drawings, claims, and detailed description of the present disclosure.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a block diagram schematically illustrating an energy storage and distribution system according to an embodiment of the present disclosure;
FIG. 2 is a block diagram schematically illustrating an energy storage system and a controller, according to an embodiment of the present disclosure;
FIG. 3 is a diagram illustrating coupling between an inverter and a storage device, according to an embodiment of the present disclosure;
FIG. 4 is an exploded perspective view of the inverter of FIG. 3;
FIG. 5 is a diagram illustrating an inverter with its door in an open state, according to an embodiment of the present disclosure;
FIG. 6 is a front view of the inverter of FIG. 5 with its door removed;
FIG. 7 is a plan view of the inverter of FIG. 6;
FIG. 8 is a perspective view of a main cover according to an embodiment of the present disclosure;
FIG. 9 is a perspective view of a sub-cover according to an embodiment of the present disclosure;
FIG. 10 is a perspective view of the sub-cover of FIG. 9, viewed from a different angle; and
FIG. 11 is a cross-sectional view taken along line I-I' of FIG. 5.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. Expressions such as "at least one of," when preceding a list of elements, modify the entire list of elements and do not modify the individual elements of the list.

As the present disclosure allows for various changes and numerous embodiments, particular embodiments will be illustrated in the drawings and described in detail. Advantages and features of the present disclosure and a method of achieving the same should become clear with embodiments described below in detail with reference to the drawings. However, the present disclosure is not limited to the embodiments disclosed below, but may be implemented in various forms.

Hereinafter, embodiments of the present disclosure will be described in detail with reference to the accompanying drawings, and the same or corresponding components will be denoted by the same reference numerals when described with reference to the accompanying drawings, and thus, their descriptions that are already provided will be omitted.

In the following embodiments, terms such as "first," "second," etc., are used only to distinguish one component from another, and such components must not be limited by these terms.

In the following embodiments, the singular expression also includes the plural meaning as long as it is not inconsistent with the context.

In the following embodiments, the terms "comprise," "include," "have," and the like used herein specify the presence of stated features or components, but do not preclude the presence or addition of one or more other features or components.

In the following embodiments, when an element such as a layer, region, or component is referred to as being "on," "in front of," "behind," or "under" another element, it may encompass cases where the elements are in direct contact, as well as cases where intervening elements may be present.

For convenience of descriptions, the magnitude of components in the drawings may be exaggerated or reduced. For example, the size and thickness of each element illustrated in the drawings are provided arbitrarily for convenience of descriptions, and thus, the present disclosure is not necessarily limited to those illustrated in the drawings.

In addition, it should be understood that some elements may be omitted, only a part of an element may be illustrated, or an element may be schematically represented in the drawings for the purpose of simplification, or when deemed sufficient or necessary for the description.

In the following embodiments, when an element is referred to as being "connected" to another element, this may include both cases where they are directly connected and cases where they are indirectly connected with other elements therebetween.

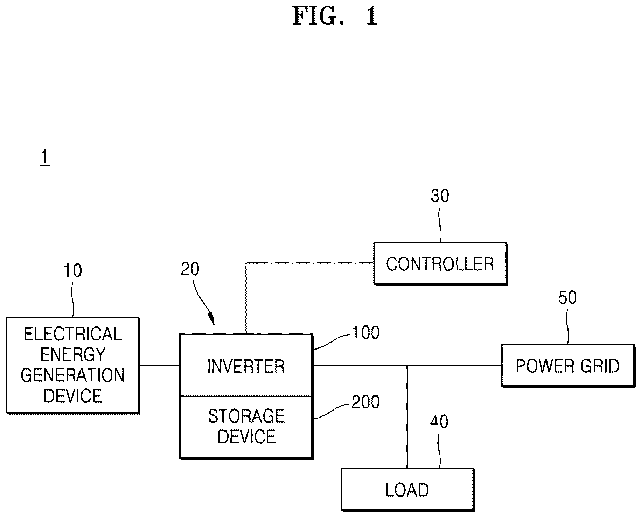

FIG. 1 is a block diagram schematically illustrating an energy storage and distribution system according to an embodiment of the present disclosure.

Referring to FIG. 1, an energy storage and distribution system 1 may convert direct current (DC) electricity generated from an electrical energy generation device 10 such as a solar module, into alternating current (AC) electricity, and supply the AC electricity to a load 40, a power grid 50, and the like, or may store power generated from the electrical energy generation device 10 in a storage device 200, and then convert and supply the stored power as needed.

The electrical energy generation device 10 refers to a device that generates electrical energy by converting various forms of energy, and may generate electrical energy in various ways depending on the type of energy source.

For example, the electrical energy generation device 10 may be a solar module that converts sunlight into electrical energy by using a solar panel. However, the present disclosure is not limited thereto, and the electrical energy generation device 10 may be provided as various devices, such as a wind power generation device or a hydroelectric power generation device.

An energy storage system 20 stores electricity generated from the electrical energy generation device 10, such as a solar module, and converts the stored DC electricity into AC electricity to supply the AC electricity to an external destination, and may include an inverter 100 and the storage device 200.

The inverter 100 may be connected to or integrated with the storage device 200. Accordingly, DC electricity generated from the electrical energy generation device 10 may be stored in the storage device 200 and then converted into AC electricity by the inverter 100 to be supplied to the load 40, the power grid 50, and the like, as needed.

However, the present disclosure is not limited thereto, and within the technical scope of being able to mutually convert between DC electricity and AC electricity from an external source, the inverter 100 may be connected to or integrated with various components of the energy storage and distribution system, such as a converter, a battery management system (BMS), or a power management system.

A controller 30 is electrically connected to the energy storage system 20, and may receive operation data from the energy storage system 20 to monitor its operational status and control its operating conditions.

In some embodiments, the controller 30 may check the operational status of the inverter 100 in real time. In some embodiments, the controller 30 may receive, from the inverter 100, information about various parameters of the electrical energy generation device 10, such as the total amount of power generation or the AC voltage. In some embodiments, when a defect or failure occurs during the operation of the inverter 100, the controller 30 may generate an alarm to notify a user.

The load 40 is a general term referring to any device that consumes electricity, and examples of the load 40 may include household electrical appliances, heating and cooling systems, lighting and equipment in commercial facilities, and machinery in industrial sites. In general, because the load 40 uses AC electricity, DC electricity introduced to charge the storage device 200 is converted into AC electricity by the inverter 100 and then supplied to the load 40.

The power grid 50 may be defined as a power network that transmits and distributes AC electricity, which has been converted by the inverter 100, to supply the AC electricity to consumers. The power grid 50 may be connected to an electrical distribution network of a house or building to distribute electrical energy supplied from the electrical energy generation device 10 or the energy storage system 20.

In other words, the energy storage and distribution system 1 according to an embodiment of the present disclosure may be a power network where electrical energy generated from the electrical energy generation device 10 enters the energy storage system 20 to be stored in the storage device 200, or the stored electrical energy is converted and supplied to the load 40 and the power grid 50 to be ultimately delivered to consumers.

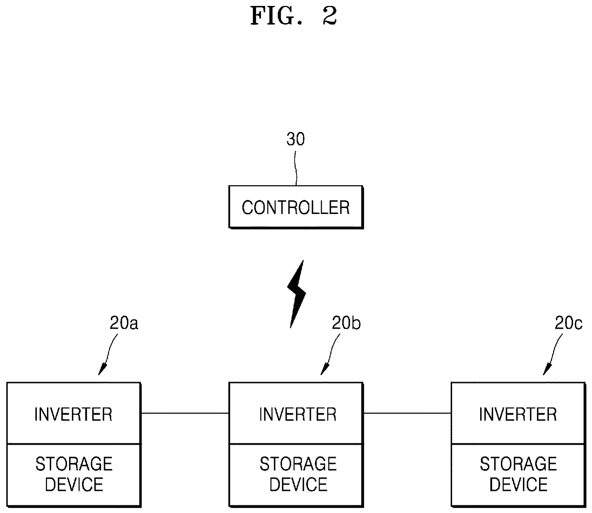

FIG. 2 is a block diagram schematically illustrating an energy storage system and a controller, according to an embodiment of the present disclosure.

Referring to FIG. 2, a plurality of energy storage systems 20 may be provided and connected to each other. The number of energy storage systems 20 is not limited to a specific number and may be variously configured depending on the installation location of the energy storage systems 20, or the like. However, for convenience of descriptions, the following description will focus on an embodiment in which three energy storage systems 20a, 20b, and 20c are connected to the controller 30.

In an embodiment, the energy storage systems may include a first energy storage system 20a, a second energy storage system 20b, and a third energy storage system 20c, which may be electrically connected to each other. For example, the first energy storage system 20a, the second energy storage system 20b, and the third energy storage system 20c may be connected to each other by cables to transmit electrical signals or to allow current to flow between them.

The controller 30 according to an embodiment of the present disclosure may be connected to the first energy storage system 20a, the second energy storage system 20b, and the third energy storage system 20c via wired or wireless communication.

In a case in which the controller 30 is connected via a wired connection to the first energy storage system 20a, the second energy storage system 20b, and the third energy storage system 20c, the controller 30 may be connected to a storage device of any one of the first energy storage system 20a, the second energy storage system 20b, and the third energy storage system 20c, and may receive operation data from the other storage devices.

In another embodiment, the controller 30 may be connected to each of the first energy storage system 20a, the second energy storage system 20b, and the third energy storage system 20c to receive their respective operation data.

In some embodiments, the controller 30 may be wirelessly connected to the energy storage system 20 to receive operation data via wireless communication.

As the controller 30 monitors information about the energy storage system 20 and the inverter 100 in real time and adjusts operating conditions, it is possible to immediately respond to a problem occurring during the operation of the inverter 100, and a power consumption or the like is output in real time such that processes of generating, storing, and distributing electrical energy are performed more efficiently.

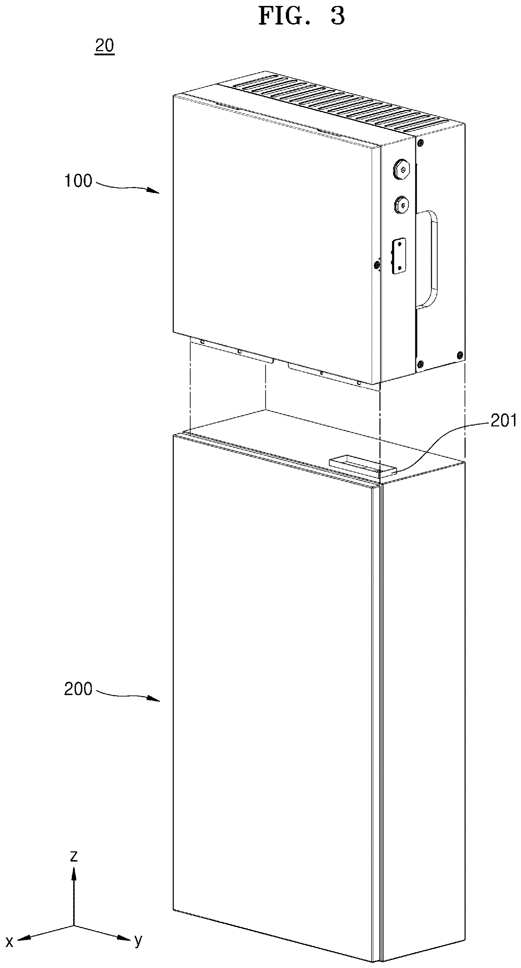

FIG. 3 is a diagram illustrating coupling between an inverter and a storage device, according to an embodiment of the present disclosure.

The energy storage system 20 according to an embodiment of the present disclosure may include the inverter 100 and the storage device 200.

The inverter 100 and the storage device 200 may be electrically connected to each other via a DC connector or AC connector (not shown), and accordingly, the inverter 100 may receive DC electricity or convert the received DC electricity into AC electricity to transmit the AC electricity to an external destination.

In other words, the inverter 100 may be electrically connected to the storage device 200 to supply power to the storage device 200, or receive power from the storage device 200 to output the power to an external destination.

The inverter 100 may be coupled to the storage device 200 in a vertical direction. In the present specification, the term "vertical direction" may refer to a z-axis direction, an up-down direction in FIG. 3, and a lengthwise direction of the storage device 200.

In some embodiments, the inverter 100 may be connected to a connection protrusion 201 of the storage device 200. The connection protrusion 201 may have the shape of a partition wall that surrounds a preset area of the storage device 200 that faces the inverter 100.

Here, a connection cable, a wire, a connector, or the like, which electrically connects the inverter 100 to the storage device 200, may pass through a surface of the storage device 200 that is enclosed by the connection protrusion 201 to be connected to a connection terminal inside the inverter 100. Details regarding the coupling between the connection protrusion 201 and the inverter 100 will be described in detail below.

The storage device 200 may be a power storage device for storing electrical energy supplied from an external electrical energy generation device 10.

Thus, although the present specification describes an example in which the storage device 200 is a power storage device, the present disclosure is not limited thereto, and various modifications may be made to other external devices within the technical scope where the storage device 200 may be electrically connected to the inverter 100 capable of mutually converting between DC power and AC power.

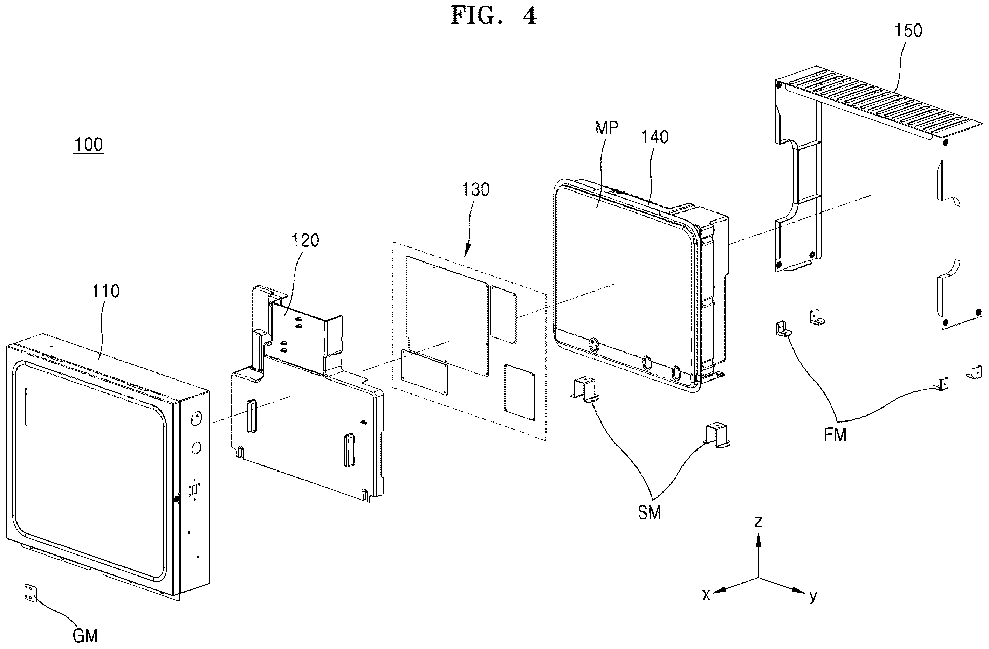

FIG. 4 is an exploded perspective view of the inverter of FIG. 3.

Referring to FIG. 4, the inverter 100 is capable of mutually converting between DC electricity and AC electricity supplied from an external source, and may include a main case 110, a safety cover 120, a circuit board unit 130, a heat dissipation case 140, and a hood cover 150.

The main case 110, the safety cover 120, the circuit board unit 130, and the heat dissipation case 140 may be coupled to each other in a first direction. In the present specification, the term "first direction" may refer to an x-axis direction, and the term "second direction" may refer to a y-axis direction.

The main case 110 may be connected to the storage device 200 through a fixing member GM. The heat dissipation case 140, which covers one side of the main case 110 and has a plurality of heat dissipation fins 143, defines an internal space in which the circuit board unit 130 may be arranged.

In the present specification, the term "internal space" may refer to a space that is defined by the assembly of the main case 110 and the heat dissipation case 140. In other words, the internal space may refer to a space enclosed by the main case 110 and the heat dissipation case 140.

In some embodiments, the safety cover 120 that covers the circuit board unit 130 may be arranged in the internal space. The safety cover 120 is arranged on one side of the circuit board unit 130 and protects a plurality of circuit boards from an external environment, and may prevent the circuit boards from being exposed to the external environment during the installation of the inverter 100, and may reduce the likelihood of failure and malfunction of the inverter 100.

In some embodiments, the safety cover 120 may physically separate components through which current flows, from a worker, thereby preventing electric shock accidents and enhancing the safety of the working environment.

The circuit board unit 130 may be arranged in the internal space and may have at least one circuit board capable of mutually converting between DC power and AC power.

In an embodiment, the circuit board unit 130 may have a plurality of circuit boards, and may include a first board, a second board, a third board, and a fourth board. Here, the circuit boards may be referred to as "circuit boards" or "a plurality of circuit boards".

Each circuit board may be provided as a filter board, a main board, a battery management and protection system (BMPS) board, a switching-mode power supply (SMPS) board, or the like, and may include power semiconductors such as metal-oxide-semiconductor field-effect transistors (MOSFETs) or insulated-gate bipolar transistors (IGBTs), control circuits, sensors, a printed circuit board, and the like. Here, the respective circuit boards may be stacked and arranged within the internal space, or may be arranged to be spaced apart from each other on the same plane.

A main plate MP may be arranged between the safety cover 120 and the heat dissipation case 140. The main plate MP, which supports at least one circuit board of the circuit board unit 130, may partition the internal space.

The circuit board unit 130 may be arranged on opposite sides of the main plate MP. In other words, the plurality of circuit boards may be arranged in the multiple spaces that are partitioned by the main plate MP.

Although not shown in the drawings, the plurality of circuit boards may be arranged not only in the space between the safety cover 120 and the main plate MP but also in the space between the main plate MP and the heat dissipation case 140.

Accordingly, the plurality of circuit boards included in the circuit board unit 130 may be stacked in the first direction within the internal space of the inverter 100.

The safety cover 120 may be fastened and fixed to the main plate MP. In other words, the safety cover 120 may be fixed in place on the main plate MP while covering a portion of the circuit board unit.

The main plate MP may be pre-assembled with a plurality of coupling members (not shown), which support the safety cover 120 and connect the main plate MP to the safety cover 120.

In an embodiment, the coupling member may be provided as a supporter that may fix the safety cover 120 in position on the main plate MP and evenly distribute the load of the safety cover 120 to provide a stable support structure. In an embodiment, the coupling member may be provided as a standoff that is designed to maintain a preset interval between the safety cover 120 and the main plate MP.

The heat dissipation case 140 may be formed to protrude in the first direction. As the heat dissipation case 140 is formed to protrude outward, an inner side of the protruding area is concavely formed, thereby providing an internal space.

At least one circuit board may be accommodated in the space enclosed by the heat dissipation case 140 and the main plate MP. Accordingly, the plurality of circuit boards included in the circuit board unit 130 may be completely enclosed by the main case 110, the safety cover 120, and the heat dissipation case 140.

The heat dissipation case 140 has a plurality of heat dissipation fins and may efficiently dissipate heat generated from the circuit board unit 130 to the outside. Accordingly, the heat dissipation case 140 may prevent excessive heat from accumulating inside the inverter 100 to cause performance degradation of the circuit boards or defects during operation.

The hood cover 150 surrounds the heat dissipation case 140 and connects to the main case 110, and may be arranged to cover the side and upper surfaces of the heat dissipation case 140, thereby protecting the heat dissipation case 140 from the outside.

In some embodiments, the hood cover 150 may physically block a user or worker from contacting the surface of the heat dissipation case 140, which reaches a high temperature due to heat generated from the internal circuit boards, thereby protecting the user and worker.

A lower portion of the hood cover 150 may be connected to the upper surface of the storage device 200. In some embodiments, areas corresponding to the corners of the lower portion of the hood cover 150 may be fastened to the storage device 200 by fastening members FM, respectively. Accordingly, the inverter 100 may be securely fixed on the storage device 200.

The fastening member FM is fastened to the hood cover 150 and may connect the hood cover 150 to the storage device 200.

A plurality of fastening members FM may be provided. Some of the plurality of fastening members FM may be welded to a rear surface portion of a main body 111 to fix four corners of the hood cover 150 to the main body 111.

In some embodiments, others of the plurality of fastening members FM may be welded onto the storage device 200, to fix opposite lower end portions (the lower side in FIG. 4) of the hood cover 150 to the storage device 200.

Because the main case 110 is connected to the hood cover 150 by the fastening members FM, and the hood cover 150 is connected to the storage device 200, the main case 110 may be indirectly fixed to the storage device 200.

The inverter 100 may further include the fixing member GM and support members SM.

The fixing member GM, which connects the main case 110 to the storage device 200, may be formed to extend in a vertical direction, such that one side thereof may be connected to the main case 110, and the other side thereof may be connected to the storage device 200.

Accordingly, the fixing member GM may maintain the fixation between the main body 111 and a front portion (the left side in FIG. 4) of the storage device 200, even when the door 112 is opened or detached.

In some embodiments, the fixing member GM may provide guidance when the inverter 100 and the storage device 200 are connected to each other, such that each component may be aligned with a common center in a vertical direction.

The support member SM is arranged between the heat dissipation case 140 and the storage device 200, and one surface of the support member SM may contact the storage device 200, and the opposite surface may contact the heat dissipation case 140.

Accordingly, the support members SM may stably support a lower portion of the heat dissipation case 140 that protrudes in the first direction, and may space the heat dissipation case 140 apart from the storage device 200 by a preset interval.

A plurality of support members SM may be provided, and the plurality of support members SM may be respectively arranged on opposite sides of the heat dissipation case 140 to distribute the weight of the heat dissipation case 140 and thereby provide more stable support.

The upper surface (the upper side in FIG. 4) of the support member SM may undergo a masking treatment to serve as a ground connection between the heat dissipation case 140 and the storage device 200. Accordingly, the support members SM may physically support the inverter 100 and simultaneously improve the electrical stability of the entire energy storage system 20.

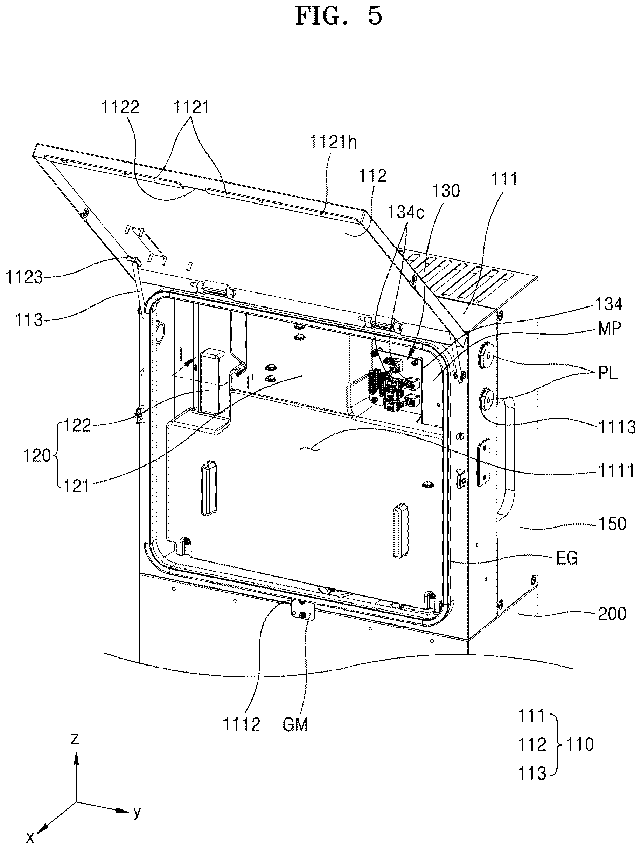

FIG. 5 is a diagram illustrating an inverter with its door in an open state, according to an embodiment of the present disclosure.

Referring to FIG. 5, the main case 110 may include the main body 111, a door 112, and safety rods 113.

The main case 110 has an internal space defined by its assembly with the heat dissipation case 140 and is installed on the storage device 200, and the safety cover 120 and the circuit board unit 130 may be arranged in the internal space of the main case 110.

The main body 111 may have an internal space therein and an opening 1111 on one of its surfaces. Here, the opening 1111 may be covered by the door 112.

The door 112 is rotatably connected to the main body 111 and is capable of covering the opening 1111, and the area of the door 112 may correspond to the surface of the main body 111 on which the opening 1111 is formed.

Accordingly, a worker, as needed, may rotate the door 112 up and down to open and close the opening 1111, or attach or detach the door 112 to or from the main body 111, to perform tasks necessary for installing and replacing the inverter 100.

In the present specification, the term "open state" of the door 112 (the state illustrated in FIG. 5) refers to a state in which the door 112 does not cover the opening 1111, is supported by the safety rods 113, and is arranged at a preset angle with respect to the main body 111, and the term "closed state" of the door 112 (the state illustrated in FIG. 3) refers to a state in which the door 112 covers the opening 1111.

The safety rods 113, which are arranged between the main body 111 and the door 112, may support the door 112 to allow the door 112 to maintain an open state.

One side of the safety rod 113 may be rotatably connected to the main body 111. In some embodiments, a slot-shaped rod hole (not shown) may be formed on one side of the safety rod 113. Here, the safety rod 113 may be constrained by a separate pin to a fixing bracket (not shown) that is arranged on a surface of the main body 111.

The rod hole extends in the lengthwise direction of the safety rod 113, and the safety rod 113 may perform not only rotational movement but also sliding movement in a vertical direction with respect to the main case 110.

Thus, when the safety rod 113 is hung on a rod support part 1123 and the door 112 forms a preset angle with respect to the main case 110, the safety rod 113 may slide down in the direction of gravity to be fixed in place.

Accordingly, when the door 112 moves partially due to an external force, such as a worker hitting it with their head or wind lifting it, the risk of the door 112 falling and injuring the worker may be physically prevented, and the safety of the working environment may be ensured.

Another side of the safety rod 113, which is not connected to the main body 111, may move freely to support the door 112 as the door 112 opens or closes, or may be located on a surface of the main body 111.

Referring to FIG. 5, a shielding member EG may be arranged along the circumference of the opening 1111 of the main body 111. The shielding member EG may block electromagnetic waves that are generated by current flowing through the circuit board unit 130 arranged in the internal space of the main body 111, thereby preventing the electromagnetic waves from being emitted to the outside.

The shielding member EG may be formed of various materials. For example, the shielding member EG may be formed of aluminum, steel, polycarbonate, acrylonitrile butadiene styrene (ABS), silicone, rubber, or the like, and may be arranged along the circumference of the opening 1111, and various modifications to the material are possible within the technical scope where the material is capable of blocking electromagnetic waves emitted from the circuit board unit 130.

A guide protrusion 1112 may be formed to protrude from a surface of the main case 110. In some embodiments, the guide protrusion 1112 may be arranged on a lower side (the lower side in FIG. 5) of the main case 110 that is adjacent to the storage device 200.

The guide protrusion 1112, which protrudes in the first direction, may be arranged on the surface of the main body 111 on which the opening 1111 is formed. The guide protrusion 1112 may be connected to the fixing member GM to align the inverter 100 and the storage device 200 in a line.

In some embodiments, a separate protrusion may be formed on a surface of the storage device 200 to be arranged on the same plane as the guide protrusion 1112, and the fixing member GM may be simultaneously fit-coupled to the guide protrusion 1112 and the protrusion of the storage device 200 to linearly align the two devices.

A cable hole 1113, through which a cable for electrically connecting the inverter 100 to an external device may pass, may be formed on a surface of the main body 111. Here, the cable passing through the cable hole 1113 may be any of various types of cables, such as a power cable or a communication cable.

A plurality of cable holes 1113 may be arranged in a vertical direction on a surface of the main body 111. Accordingly, a plurality of cables connected to the inverter 100 may simultaneously pass through the main body 111 to connect to the internal circuit board unit 130 or to supply power.

In some embodiments, the cable holes 1113 may be arranged on opposite sides of the main body 111, respectively. Accordingly, a cable may selectively enter the left or right side of the inverter 100 to be easily connected to the circuit board unit 130.

In an embodiment, a communication cable that receives a signal from an external source may enter the inverter 100 through the cable hole 1113 formed on the left side of the main body 111, pass the safety cover 120, and be connected to the circuit board unit 130. Here, another communication cable that is connected to the circuit board unit 130 and transmits a signal to the outside may exit the inverter through the cable hole 1113 formed on the right side of the main body 111.

A cable that transmits a signal from another inverter to the inverter 100, or a cable that transmits a signal from the inverter 100 to another inverter, may enter one side of the inverter 100 to be connected to the circuit board unit 130, or may be connected to the circuit board unit 130 to exit to another side of the inverter 100.

A plug PL is coupled to the cable hole 1113 to seal the cable hole 1113 from the outside, and may be formed to have an outer diameter greater than an inner diameter of the cable hole 1113.

By using the plug PL, a gap between the cable and the cable hole 1113 may be completely filled, and external contaminants, moisture, and the like may be prevented from entering the interior space.

When a cable connection is needed, the plug PL may be removed. A separate connector may be inserted into the cable hole 1113 from which the plug PL has been removed. For example, the connector may be a conduit connector.

The connector, with a cable mounted therein, may be inserted into the cable hole 1113 to seal the cable hole 1113. Accordingly, damage to the cable may be prevented, and dust, moisture, and other external contaminants may be prevented from entering the internal space. In some embodiments, a cable that is mounted on the connector and has passed through the cable hole 1113 may be stably fixed in position and connected to the circuit board.

The door 112, which is rotatably connected to the main body 111 and is capable of covering the opening 1111, may prevent the circuit board unit 130 inside the main body 111 from being exposed to the outside.

In some embodiments, the door 112 may be hinge-connected to the main body 111 to be rotatable within a preset radius range. Accordingly, when installation of the inverter 100 is required, an operator may rotate and open the door 112 to expose internal terminals and the like, and after the installation is complete, may rotate the door 112 again to switch to a closed state such that the interior is not exposed.

However, the present disclosure is not limited thereto, and during the installation of the inverter 100, a worker may remove the door 112 to perform a necessary task, and reattach the door 112 after the task is completed.

The door 112 may have an area corresponding to a surface of the main body 111 on which the opening 1111 is formed, and may completely cover the opening 1111 to prevent external contaminants from being introduced into the main body 111 through the opening 1111.

The door 112 may include extension tabs 1121 that are connected to the storage device 200. The extension tab 1121 is an area that extends toward the storage device 200 in a state in which the door 112 is closed, and may contact a surface of the storage device 200. In some embodiments, the extension tab 1121 may be arranged in the second direction at an end portion of the door 112.

The extension tab 1121 may be an area that is fastened to the storage device 200 and may have fixing holes 1121h arranged to be spaced apart from each other by a preset interval. The fixing holes 1121h may be arranged to be spaced apart from each other in the second direction on the extension tab 1121.

The extension tab 1121 may contact a surface of the storage device 200 in a state in which the door 112 covers the opening 1111, i.e., in a state in which the door 112 is closed, and here, the position of the fixing hole 1121h may correspond to the position of a hole formed in the storage device 200. In this state, the door 112 and the storage device 200 may be fastened together by using fastening elements such as nuts or screws.

As the extension tabs 1121 are fastened to the storage device 200 while the door 112 is in a closed state, the inverter 100 may be stably fixed to the storage device 200, and as the door 112 is fixed in the closed state, the circuit board unit 130 inside the main body 111 may be prevented from being exposed to the outside.

A plurality of the extension tabs 1121 may be provided. In an alternative embodiment, the extension tabs 1121 may be arranged on opposite sides of the door 112, respectively.

The plurality of extension tabs 1121 may be arranged to be spaced apart from each other by a preset interval. A recess 1122 refers to a gap formed by the plurality of extension tabs 1121 being arranged to be spaced apart from each other, and may be an area that does not extend from the door 112.

When the door 112 is in a closed state, the fixing member GM may be located in the recess 1122, which is a gap between the extension tabs 1121. In some embodiments, when the door 112 is fastened to the storage device 200 in a closed state, one side of the fixing member GM that is connected to the inverter 100 may be covered by the door 112, and another side that is connected to the storage device 200 may be located in the recess 1122.

As the extension tabs 1121 are fastened to the storage device 200 and opposite sides of the fixing member GM connect the storage device 200 to the main body 111, the inverter 100 may form a dual coupling with the storage device 200.

The rod support part 1123 may be further formed on a surface of the door 112 that faces the main body 111. The rod support part 1123, which is formed to protrude in the first direction with reference to the closed state of the door 112, may support the safety rod 113 when the door 112 is open.

In some embodiments, the rod support part 1123 may be formed to protrude in a shape that encloses one end portion of the safety rod 113 that contacts the door 112. A hollow portion, in which the safety rod 113 is seated, may be formed on the surface of the rod support part 1123 that contacts the door 112.

When the door 112 opens at a preset angle with respect to the main body 111, one end portion of the safety rod 113, which was fixed to a surface of the main body 111, may be lifted up and fit into the hollow portion of the rod support part 1123, and accordingly, the safety rod 113 may stably fix and support the door 112.

The door 112 may be supported by the safety rod 113 through contact, and thus prevented from being closed.

In a case in which the safety rods 113 are arranged on opposite sides of the main body 111, respectively, the rod support parts 1123 may also be arranged on opposite sides of the door 112, respectively. Accordingly, a plurality of safety rods 113 may contact a plurality of rod support parts 1123, and the door 112 may be prevented, by the plurality of safety rods 113, from tilting due to its own weight, and may stably maintain the open state.

The safety rod 113, which has one end rotatably connected to the main body 111 and another end supported by the door 112, may have the shape of an elongated rod.

The safety rod 113 may be arranged between the main body 111 and the door 112, to support the door 112, allowing the door 112 to maintain the open state without closing. In some embodiments, the safety rod 113 may be capable of sliding movement in a vertical direction through a rod hole, which is formed in a slot shape at one end portion thereof connected to the main body 111.

In a state in which the door 112 is open, one end of the safety rod 113 may be rotatably connected to the main body 111, and another end may be supported through contact by the rod support part 1123 of the door 112. Accordingly, the door 112 may stably maintain the open state.

Referring to FIG. 5, the safety cover 120, which is arranged in the internal space to cover the circuit board unit 130, may include a main cover 121 and a sub-cover 122.

The safety cover 120 may be arranged inside the main body 111 and may be an area that is exposed when the door 112 is opened. Accordingly, the circuit board arranged on the main plate MP may be protected by the safety cover 120 without being exposed to the outside, even when the door 112 is open.

The safety cover 120 may be formed of a material having insulating properties. For example, the safety cover 120 may be formed of a thermoplastic plastic such as polyvinyl chloride (PVC) or polycarbonate (PC), a thermosetting plastic such as epoxy resin or melamine resin, or a metal cover whose surface is treated with an insulating coating.

A portion of a circuit board 134 arranged on the main plate MP may be exposed to the outside without being covered by the safety cover 120. The portion of the circuit board 134 that is exposed to the outside may be an area to which various cables, such as a communication cable or a power cable, are connected during the installation of the inverter 100.

In other words, a connection terminal 134c, to which various cables may be connected, may be arranged in the portion of the circuit board 134 that is exposed to the outside. A cable connected to an external source may be coupled to the connection terminal 134c and thus electrically connected to the circuit board.

Here, the cable connected to the external source may enter the inverter 100, specifically the main body 111, through the cable hole 1113. In some embodiments, when a cable connection is necessary, an operator may remove the plug PL, then mount the cable on a separate connector, and connect the connector to a circuit board inside the main body 111.

As cable holes 1113 are arranged on opposite sides of the main body 111, a cable may easily enter the inverter 100 from either the left side (the left side in FIG. 5) or the right side (the right side in FIG. 5) of the inverter 100, to be connected to a circuit board.

The main cover 121 may cover the entire circuit board 134 except for the portion that is exposed to the outside. Accordingly, during the installation of the inverter 100, the circuit board 134 to which worker contact is prohibited may be safely protected by the safety cover 120, and only a portion of the circuit board 134 in which the connection terminal 134c is arranged may be exposed, enabling an easy installation process.

The sub-cover 122, which covers a fuse mounted on the circuit board unit 130, may be arranged on a surface of the main cover 121. The sub-cover 122 may be coupled to the main cover 121 in a snap-fit manner, to be easily detached from the main cover 121 when fuse replacement is necessary.

The sub-cover 122 will be described in detail below.

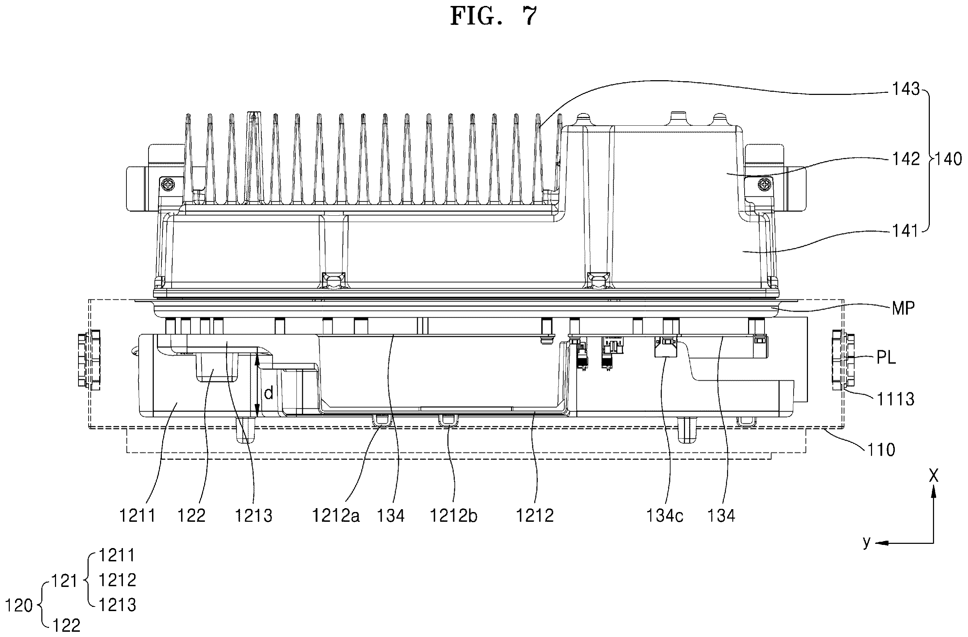

Referring to FIGS. 4 and 7, the heat dissipation case 140, which covers one side of the main case 110 and has a plurality of heat dissipation fins 143, may include a first body 141, a second body 142, and the plurality of heat dissipation fins 143.

The first body 141 has an internal space and accommodates the circuit board unit 130, and the heat dissipation fins 143 may be formed on a side of the first body 141 that is opposite to the side on which the circuit board unit 130 is arranged. In some embodiments, the circuit board unit 130 may be arranged on an inner surface IS of the first body 141, which forms an internal space, and the heat dissipation fins 143 may be formed on the surface opposite to the inner surface IS to protrude outward.

Accordingly, heat generated from a circuit board arranged in the internal space may be transferred through the first body 141 to the heat dissipation fins 143 and effectively dissipated to the outside.

The second body 142, which is arranged adjacent to the heat dissipation fins 143 and has an internal space, may be formed to protrude from the first body 141 in the first direction. As the second body 142 protrudes outward, a space in which a circuit board may be additionally accommodated may be formed inside the second body 142.

Accordingly, inside the inverter 100 according to an embodiment of the present disclosure, a plurality of circuit boards that constitute the circuit board unit 130 may be stacked to be supported by the main plate MP, the first body 141, and the second body 142.

A plurality of heat dissipation fins 143 may be provided and arranged on a surface of the heat dissipation case 140 to protrude outward.

The heat dissipation fins 143 may extend in a vertical direction, may each have a long and thin shape, and may be arranged on the heat dissipation case 140 to be spaced apart from each other by a preset interval. Due to such an optimized structure of the heat dissipation fins 143, the surface area of the heat dissipation case 140 may be maximized, and the heat dissipation efficiency may be increased.

The heat dissipation fins 143 may be formed of various materials, for example, a metallic material with high thermal conductivity, such as aluminum or copper. However, the present disclosure is not limited thereto, and various modifications to the material are possible within the technical scope where the material has high thermal conductivity and is capable of efficiently dissipating heat from the inside of the heat dissipation case 140.

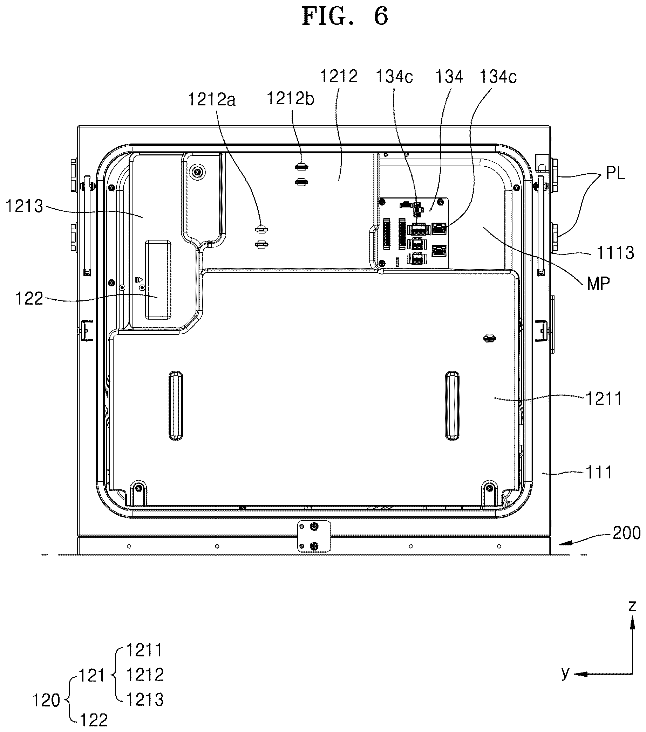

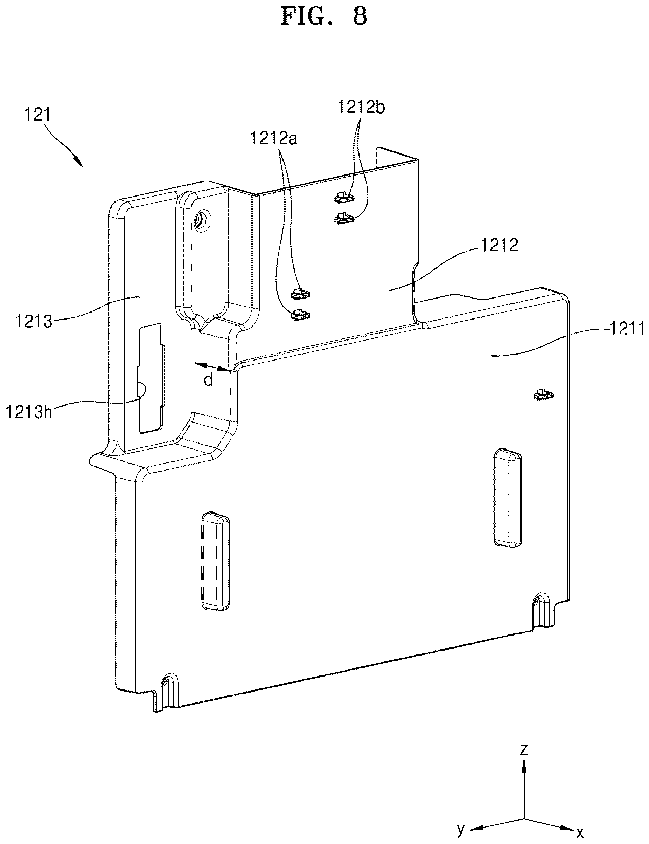

FIG. 6 is a front view of the inverter of FIG. 5 with its door removed, FIG. 7 is a plan view of the inverter of FIG. 6, and FIG. 8 is a perspective view of a main cover according to an embodiment of the present disclosure.

Referring to FIGS. 6, 7, and 8, the safety cover 120 is arranged in the internal space to cover the circuit board unit 130, and may include the main cover 121 and the sub-cover 122.

The safety cover 120 may cover the circuit board 134 arranged on the main plate MP. Thus, even when the door 112 is open, the circuit boards 134 arranged on the main plate MP may be protected without being exposed to the outside.

The main cover 121 covers at least a part of the circuit board unit 130 and may include a first cover body 1211, a second cover body 1212, and a third cover body 1213.

The first cover body 1211 covers the circuit board 134, and specifically, may cover the lower side (the lower side in FIG. 6) of the main plate MP.

The first cover body 1211 may be connected to the second cover body 1212 and the third cover body 1213. In some embodiments, the second cover body 1212 may be arranged on the upper side (the upper side in FIG. 6) of the first cover body 1211, and the third cover body 1213 may be arranged on the left side (the left side in FIG. 6) of the first cover body 1211.

The first cover body 1211 may have a larger area than the second cover body 1212 and the third cover body 1213, and may cover the circuit board 134.

The first cover body 1211, the second cover body 1212, and the third cover body 1213 may be integrally formed, but are not limited thereto, and may be respectively formed as separate parts and then connected to each other.

The second cover body 1212 may be arranged on one side of the first cover body 1211, and may cover the upper side (the upper side in FIG. 6) of the main plate MP.

The second cover body 1212 may have guide parts 1212a and 1212b that guide cables connected from the outside of the main case 110 to the connection terminals 134c of the circuit board 134.

The guide parts 1212a and 1212b may each be formed in the shape of a loop protruding outward from a surface of the safety cover 120. A plurality of the guide parts 1212a and 1212b may be provided and arranged to be spaced apart from each other by a preset interval.

The interval between the guide parts 1212a and 1212b, which are arranged to be spaced apart from each other, may be greater than or equal to the diameter of the cable connected to the outside. Thus, the cables entering the main body 111 through the cable holes 1113 may be fitted between the guide parts 1212a and 1212b, which are arranged to be spaced apart from each other, and fixed in position.

Therefore, paths for cables may be formed by the arrangement of the guide parts 1212a and 1212b.

For example, a plurality of the guide parts 1212a and 1212b may be arranged to be spaced apart from each other in a vertical direction (the up-down direction in FIG. 6) on the second cover body 1212. In this case, cables may be fitted between the guide parts 1212a and 1212b, which face each other in a vertical direction, to be arranged in the second direction (the left-right direction in FIG. 6).

A plurality of guide parts 1212a and 1212b facing each other may be arranged on the second cover body 1212. In some embodiments, when there are a plurality of cables connected to the outside, one cable may be guided by the guide part 1212a through a path, and another cable may be guided by the guide part 1212b through another path.

Accordingly, even when a plurality of cables enter from the outside, the cables may be arranged on the safety cover 120 along different respective paths without being crossed or tangled with each other, and the plurality of aligned cables may be seamlessly connected to the respective connection terminals 134c.

In addition to the above-described embodiments, the guide parts 1212a and 1212b may be arranged on the first cover body 1211, the second cover body 1212, and the third cover body 1213 to guide cables through various paths.

At least some of the circuit boards 134 may be exposed to a space enclosed by the first cover body 1211 and the second cover body 1212. In other words, the third cover body 1213 and the exposed circuit boards 134 may be arranged on opposite sides of the second cover body 1212, respectively.

Hereinafter, for convenience of descriptions, the space enclosed by the first cover body 1211 and the second cover body 1212 is defined as a "connection space", and the circuit boards 134 that are arranged in the connection space and exposed to the outside will be referred to as "externally exposed boards".

The safety cover 120 is connected to the main plate MP on which the circuit boards 134 are arranged, and in a state in which the safety cover 120 is mounted on the main plate MP, only the externally exposed boards arranged in the connection space may be connected to the outside.

The externally exposed board may include the connection terminal 134c arranged in the connection space and to which an external cable is connected.

For example, the connection terminal 134c may be provided as a power cable connection terminal to which a power cable for supplying power from an external source is connected, a communication cable connection terminal that transmits operation data regarding the inverter 100 to the outside, a connection terminal for a cable that electrically connects to a plurality of adjacent inverters 100, or the like.

However, the present disclosure is not limited thereto, and the connection terminal 134c arranged on the externally exposed board may be provided as a cable connection terminal that connects a plurality of circuit boards, which are included in the circuit board unit 130, to each other.

When an operator opens the door 112 for installation and replacement of the inverter 100, the internal circuit board unit 130 is not revealed due to the safety cover 120, and only the externally exposed boards arranged in the connection space may be directly exposed to the outside.

In general, when an operator installs or replaces the inverter 100, an operation of connecting or disconnecting a cable that connects the inverter 100 to the outside is essential.

The inverter 100 according to an embodiment of the present disclosure doubly protects the internal circuit board unit 130 with the door 112 and the safety cover 120, and when the door 112 is opened, only the externally exposed boards, to which connection of cables is essential, are exposed to the outside, which may improve the convenience of installation and replacement operations.

Furthermore, the safety cover 120 may physically separate components through which current flows, from a worker, thereby preventing electric shock accidents and enhancing the safety of the working environment during installation and replacement operations for the inverter 100.

Furthermore, because the connection terminal 134c that requires connection to the outside is arranged in the connection space, an operator may efficiently perform connection and release of a cable, and the time required for installation and replacement of the inverter 100 may be shortened.

The third cover body 1213 may be connected to the first cover body 1211 and the second cover body 1212, and may have a step d with at least one of the first cover body 1211 and the second cover body 1212. The third cover body 1213 may have a coupling hole 1213h in which the sub-cover 122 is installed. The third cover body 1213 may be arranged closer to the circuit boards 134 than are the first cover body 1211 and the second cover body 1212.

It may also be described that the third cover body 1213 is arranged to have a preset height difference d with respect to the first cover body 1211 and the second cover body 1212.

The third cover body 1213 may be formed to be recessed from the second cover body 1212 toward the internal space.

Because the third cover body 1213 and the connection space are respectively arranged on opposite sides of the second cover body 1212, and the second cover body 1212 has the step d with the third cover body 1213, the second cover body 1212 may also have a step with the externally exposed boards.

Thus, the second cover body 1212, the third cover body 1213, and the externally exposed boards are not arranged on the same plane but may be arranged at different respective heights with respect to the main plate MP.

The third cover body 1213 may be enclosed by the first cover body 1211, the second cover body 1212, and the main body 111. In some embodiments, the upper side and the left side of the third cover body 1213 may be enclosed by the main body 111, the second cover body 1212 may be arranged on the right side of the third cover body 1213, and the first cover body 1211 may be arranged on the lower side of the third cover body 1213.

The third cover body 1213 may be arranged adjacent to the cable hole 1113 of the main body 111. A cable entering through the cable hole 1113 may sequentially pass the third cover body 1213 and the second cover body 1212 to be connected to the externally exposed board.

In some embodiments, a cable that has entered the internal space through the cable hole 1113 formed on the left side of the main body 111 may first be arranged along one surface of the third cover body 1213.

The cable may be arranged in the second cover body 1212 along the step d formed between the third cover body 1213 and the second cover body 1212, and fitted between the guide parts 1212a and 1212b to be aligned in the second direction. The cable that has passed through the guide parts 1212a and 1212b may be arranged in the connection space along the step between the second cover body 1212 and the externally exposed board.

In other words, a path for the cable connected to the outside may be formed through the cable hole 1113, the third cover body 1213, the step d, and the guide parts 1212a and 1212b of the second cover body 1212, such that the cable may be connected to the connection terminal 134c of the externally exposed board.

Accordingly, it is possible to prevent cables from being twisted or entangled. Furthermore, as the cable hole 1113, the step d of the safety cover 120, and the guide parts 1212a and 1212b guide a plurality of cables through respective paths, the plurality of cables may be arranged on the safety cover 120 without overlapping.

In the inverter 100 according to an embodiment of the present disclosure, as a cable connected to the outside is routed in a curved manner along the step d, which is formed between the third cover body 1213 and the second cover body 1212 and between the second cover body 1212 and the externally exposed boards, a sufficient bending radius may be secured.

Thus, it is possible to prevent a cable connected to the connection terminal 134c from being bent with an excessively small radius, which would damage an inner conductor and insulator, or cause a signal transmitted through the cable to be lost, and furthermore, physical stress applied to the cable is reduced, which may in turn extend the lifespan of the cable.

The third cover body 1213 may further have the coupling hole 1213h in which the sub-cover 122 is installed. The coupling hole 1213h serves as a passage between the internal space of the inverter 100 and the outside, and at least a part of a fuse F mounted on a circuit board may be arranged inside the coupling hole 1213h.

Referring again to FIG. 4, the third cover body 1213 may be arranged to cover any one of a plurality of circuit boards included in the circuit board unit 130. In this case, the coupling hole 1213h may be formed at a position corresponding to the fuse F installed on the circuit board 134.

In a state in which the sub-cover 122 is removed, the fuse F may be exposed to the outside through the coupling hole 1213h. Thus, when replacement of the fuse F is necessary, an operator may remove only the sub-cover 122 to replace the fuse F, without needing to remove the entire safety cover 120, and complete the replacement by reattaching the sub-cover 122 to the main cover 121.

The coupling hole 1213h may be formed in the shape of a hole extending in a lengthwise direction. In other words, the coupling hole 1213h may be formed in a shape that substantially corresponds to the shape of the fuse F installed on the circuit board 134.

Although the coupling hole 1213h is illustrated in the drawings in the shape of a hole extending in a vertical direction, when the fuse F is arranged to extend in the second direction, the coupling hole 1213h may have a shape extending in the second direction, and when the fuse F has another shape, the coupling hole 1213h may be formed in a corresponding shape.

In some embodiments, the sub-cover 122 is coupled to the coupling hole 1213h, and the coupling hole 1213h may be formed in a shape corresponding to a surface of the sub-cover 122 that faces the coupling hole 1213h.

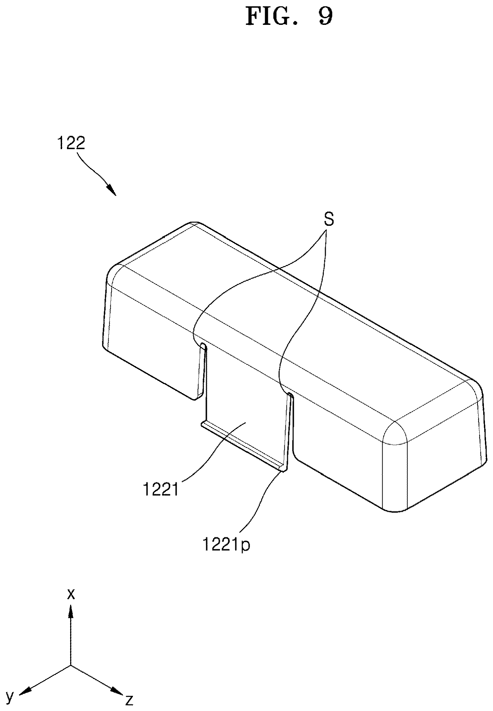

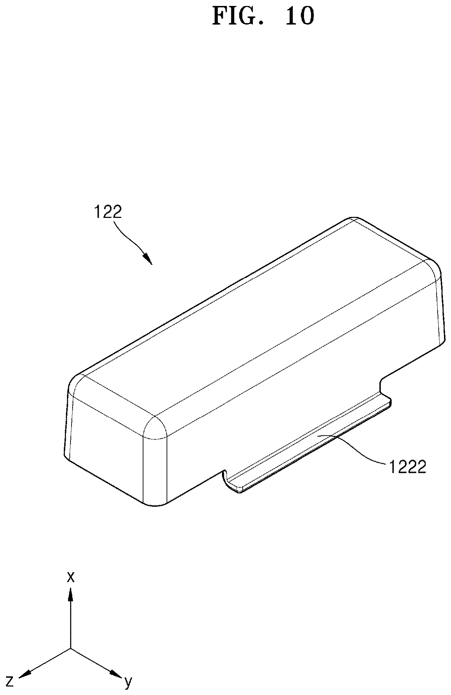

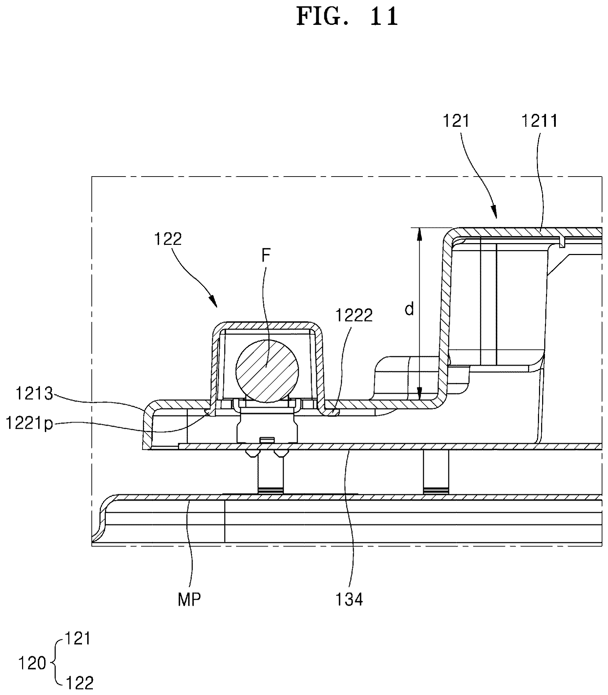

FIG. 9 is a perspective view of a sub-cover according to an embodiment of the present disclosure, FIG. 10 is a perspective view of the sub-cover of FIG. 9, viewed from a different angle, and FIG. 11 is a cross-sectional view taken along line I-I' of FIG. 5.

Referring to FIGS. 9 to 11, the sub-cover 122 may be connected to the main cover 121 and may cover the fuse F mounted on the circuit board.

The sub-cover 122 may be formed substantially in the shape of a cuboid with one surface open. Inside the cuboid, a space in which the fuse F may be accommodated may be provided. When the sub-cover 122 is mounted on the main cover 121, the open surface of the sub-cover 122 may be arranged to face the main cover 121.

The sub-cover 122 may be arranged on the third cover body 1213 to cover the coupling hole 1213h.

The circuit board 134 may be arranged such that the fuse F protrudes into the coupling hole 1213h of the main cover 121, and the sub-cover 122 may be assembled to protrude from the coupling hole 1213h to cover the fuse F.

The open surface of the sub-cover 122 may be formed in a shape corresponding to the coupling hole 1213h.

The fuse F, which is mounted on the circuit board 134 to correspond to the position of the coupling hole, may protrude outward. The sub-cover 122 may be installed in the coupling hole while surrounding the fuse F. Thus, the upper surface, lower surface, and side surfaces of the fuse F may all be covered by the sub-cover 122.

The sub-cover 122 may be detachably connected to the main cover 121. In some embodiments, one side of the sub-cover 122 may be detachably coupled to the main cover 121, and the opposite side may be fixed to the main cover 121.

Thus, when replacing the fuse F, an operator may separate one side of the sub-cover 122 from the main cover 121 to open the sub-cover 122, and after replacing the fuse F, close the sub-cover 122.

Referring again to FIG. 6, the sub-cover 122 may be arranged closer to the lower side (the lower side in FIG. 6) of the third cover body 1213 than to the upper side (the upper side in FIG. 6). It may also be described that the sub-cover 122 is arranged closer to the first cover body 1211 than to the second cover body 1212.

When the sub-cover 122 is arranged in a lower portion (the lower side in FIG. 6), the cable hole 1113 may be arranged in a relatively upper portion (the upper side in FIG. 6) with respect to the sub-cover 122. Thus, a cable entering from the cable hole 1113 and the sub-cover 122 may be arranged at different positions.

The sub-cover 122 protrudes toward the outside of the inverter 100, and as the sub-cover 122 is arranged in a lower portion of the third cover body 1213, a cable may be seamlessly connected to the second cover body 1212 without its path being obstructed by the sub-cover 122.

Hereinafter, a specific configuration of the sub-cover 122 will be described.

The sub-cover 122 is couplable to the main cover 121 in a snap-fit manner, and may have a coupling part 1221 having a locking protrusion 1221p that protrudes outward and is supported by the main cover 121.

The coupling part 1221 may be arranged at a central portion of one side wall, and may be elastically deformed by an external force.

The locking protrusion 1221p may be formed along one end portion of the coupling part 1221. The locking protrusion 1221p protrudes outward from the coupling part 1221, and may be formed to extend in the lengthwise direction of the sub-cover 122.

The locking protrusion 1221p may be formed in a hook shape or a claw shape. When the sub-cover 122 is mounted on the main cover 121, the locking protrusion 1221p may engage with a surface (the lower surface in FIG. 11) of the main cover 121 to form a stable coupling.

Slits S, each of which is formed by removing a part of one side wall, may be arranged on opposite sides of the coupling part 1221, respectively. By the slits S, opposite sides of the coupling part 1221 may be spaced apart from one side wall of the sub-cover 122.

When an external force is applied to the coupling part 1221, the coupling part 1221 may easily move back and forth (the left-right direction in FIG. 9) and be deformed without friction with one side wall, and when the external force is removed, the coupling part 1221 may be restored to its original state.

On another side wall of the sub-cover 122, which is opposite to the side wall on which the coupling part 1221 is formed, a connection part 1222 that connects the main cover 121 to the sub-cover 122 may be formed.

The connection part 1222 protrudes outward from the other side wall of the sub-cover 122, and may extend in the lengthwise direction of the sub-cover 122. The connection part 1222 may be arranged to face a surface of the main cover 121. In other words, the connection part 1222 may be formed to have a surface parallel to the main cover 121.

The connection part 1222 may be connected to the surface of the main cover 121 that faces the circuit board 134. For example, the connection part 1222 may be connected to the main cover 121 by welding. However, the present disclosure is not limited thereto, and the sub-cover 122 and the main cover 121 may be connected to each other in various manners, such as a mechanical coupling method using a bolt, a nut, a clamp, or the like, a connection method using an adhesive, or a fit coupling method.

According to an embodiment of the present disclosure, during normal operation, the sub-cover 122 may protect the fuse F as the locking protrusion 1221p of the coupling part 1221 is lock-coupled to the main cover 121.

When replacement of the fuse F is necessary, an operator may apply an external force to the sub-cover 122 to release the coupling between the coupling part 1221 and the main cover 121. In detail, when the operator applies an external force to the coupling part 1221 toward the internal space of the sub-cover 122, the coupling part 1221 may move toward the inside (the right side in FIG. 11) of the sub-cover 122. Here, as the locking protrusion 1221p is separated from the main cover 121, the coupling between the sub-cover 122 and the main cover 121 may be released.

In this state, after opening the sub-cover 122 and completing the replacement of the fuse F, the operator may mount the sub-cover 122 on the coupling hole 1213h again while applying an external force to the coupling part 1221.

When the external force pressing the coupling part 1221 is removed, the coupling part 1221 is brought back into contact with the main cover 121 by the elastic restoring force of the coupling part 1221, and seals the coupling hole 1213h. The locking protrusion 1221p may engage with the lower surface of the main cover 121 to fix the sub-cover 122 to prevent it from being separated from the main cover 121.

That is, as the sub-cover 122 is coupled to the main cover 121 in a snap-fit manner, an operator may simply couple or separate the sub-cover 122 to or from the main cover 121 without needing a separate tool or additional parts.

In the inverter 100 according to an embodiment of the present disclosure, the safety cover 120 that protects the circuit boards is formed to have a plurality of steps, and thus, a bending radius for a cable entering the inverter 100 may be secured.

Furthermore, the internal circuit board unit 130 is doubly protected by the door 112 and the safety cover 120, and only the externally exposed boards, which require a cable connection to the outside, are exposed when the door 112 is open, thereby increasing the convenience of installation and replacement operations.

Furthermore, the guide parts 1212a and 1212b that guide the paths of cables connected to the outside are respectively formed in the safety cover 120, such that a plurality of cables entering from the outside are arranged on the safety cover 120 along different respective paths to prevent them from being tangled with each other, and accordingly, the cables may be seamlessly connected to the connection terminals 134c.

Furthermore, as the sub-cover 122 that protects the fuse F is detachably coupled on the main cover 121, the fuse F may be easily replaced without a separate tool.

Although an embodiment of the present disclosure has been described above, the spirit of the present disclosure is not limited to the embodiment presented in the present specification, and those skilled in the art who understand the spirit of the present disclosure may easily suggest other embodiments by adding, modifying, or removing components within the same scope of the spirit, but these embodiments will also fall within the scope of the spirit of the present disclosure.

## Claims

1. An inverter comprising:
a main case;
a heat dissipation case that covers one side of the main case and has a plurality of heat dissipation fins;
a circuit board unit arranged in an internal space defined by an assembly of the main case and the heat dissipation case, the circuit board unit having one or more circuit boards configured to mutually convert between direct current power and alternating current power; and
a safety cover arranged in the internal space to cover the circuit board unit.

2. The inverter of claim 1, wherein the safety cover comprises:
a first cover body that covers the one or more circuit boards; and
a second cover body arranged on one side of the first cover body, and
at least some of the one or more circuit boards are exposed through a connection space enclosed by the first cover body and the second cover body.

3. The inverter of claim 2, wherein one of the one or more circuit boards comprises a connection terminal which is arranged in the connection space and to which an external cable is connected.

4. The inverter of claim 2, wherein the safety cover further comprises a third cover body that is connected to the first cover body and the second cover body, and has a step with at least one of the first cover body and the second cover body.

5. The inverter of claim 1, wherein the safety cover comprises a guide part that guides a position of a cable connected from an outside of the main case to a connection terminal of the one or more circuit boards.

6. The inverter of claim 1, wherein the safety cover comprises:
a main cover that covers at least a part of the circuit board unit; and
a sub-cover that is connected to the main cover and covers a fuse mounted on the circuit board.

7. The inverter of claim 6, wherein the main cover comprises a coupling hole in which at least a part of the fuse is arranged and the sub-cover is installed.

8. The inverter of claim 6, wherein the sub-cover comprises:
a coupling part having a locking protrusion that protrudes outward and is supported by the main cover; and
slits arranged on opposite sides of the coupling part.

9. The inverter of claim 7, wherein the circuit board is arranged such that the fuse protrudes into the coupling hole of the main cover, and
the sub-cover is assembled to protrude from the coupling hole to cover the fuse.

10. An energy storage system comprising:
an inverter; and
a storage device,
wherein the inverter comprises:
a main case;
a heat dissipation case that covers one side of the main case and has a plurality of heat dissipation fins;
a circuit board unit arranged in an internal space defined by an assembly of the main case and the heat dissipation case, the circuit board unit having one or more circuit boards configured to mutually convert between direct current power and alternating current power; and
a safety cover arranged in the internal space to cover the circuit board unit, and
the inverter and the storage device are electrically connected to each other.

11. The energy storage system of claim 10, wherein the safety cover comprises:
a first cover body that covers the one or more circuit boards; and
a second cover body arranged on one side of the first cover body, and
at least some of the one or more circuit boards are exposed through a connection space enclosed by the first cover body and the second cover body.

12. The energy storage system of claim 11, wherein the safety cover further comprises a third cover body that is connected to the first cover body and the second cover body, and has a step with at least one of the first cover body and the second cover body.

13. The energy storage system of claim 10, wherein the safety cover comprises:
a main cover that covers at least a part of the circuit board unit; and
a sub-cover that is connected to the main cover and covers a fuse mounted on the circuit board.

14. The energy storage system of claim 13, wherein the main cover comprises a coupling hole in which at least a part of the fuse is arranged and the sub-cover is installed.

15. The energy storage system of claim 13, wherein the sub-cover comprises:
a coupling part having a locking protrusion that protrudes outward and is supported by the main cover; and
slits arranged on opposite sides of the coupling part.
